# EUROPEAN PATENT SPECIFICATION

(11) **EP 3 412 446 B1**
(45) Date of publication and mention of the grant of the patent: **30.12.2020**
(21) Application number: 17746933.5
(22) Date of filing: 25.01.2017
(51) Int. Cl.: B32B 17/00, C03C 8/02, C03C 17/04, H05B 3/20, B64C 1/14

(54) **HIGHLY CONDUCTIVE TRANSPARENT LAMINATED GLASS ARTICLE**
HOCHLEITFÄHIGER TRANSPARENTER SCHICHTGLASARTIKEL
ARTICLE EN VERRE STRATIFIÉ TRANSPARENT HAUTEMENT CONDUCTEUR

(30) Priority: 03.02.2016 CN 201610075787
(43) Date of publication of application: 12.12.2018
(73) Proprietor: Wuhan Huashang Green Technology Co., Ltd., Wuhan, Hubei 430000 (CN)
(72) Inventor: LIU, Lianjia, Jinan Shandong 250031 (CN); GAI, Qingliang, Binzhou Shandong 256599 (CN); YOU, Xiaojiang, Wuhan Hubei 430015 (CN)
(74) Representative: dompatent von Kreisler Selting Werner - Partnerschaft von Patent- und Rechtsanwälten mbB
(86) International application number: PCT/CN2017/072576
(87) International publication number: WO 2017/133613

(56) References cited:
- CN-A- 101 201 152
- CN-A- 102 543 633
- CN-A- 104 464 883
- CN-A- 104 816 521
- CN-A- 105 522 791
- DATABASE WPI Week 200866 Thomson Scientific, London, GB; AN 2008-L18137 XP002793518, & CN 101 201 152 A (SHANGHAI ZUNHUA ELECTRONIC ENG LTD) 18 June 2008 (2008-06-18)
- DATABASE WPI Week 201540 Thomson Scientific, London, GB; AN 2015-301494 XP002793519, & CN 104 464 883 A (SUZHOU GERUIFENG NANO TECHNOLOGY CO LTD) 25 March 2015 (2015-03-25)

## Description

### TECHNICAL FIELD

The present invention relates to a highly conductive transparent laminated glass article, and more particularly to a highly conductive transparent laminated glass article, which belongs to the field of manufacturing an electronic device.

### BACKGROUND ART

CN 101 201 152 A discloses a conductive transparent laminated glass article, comprising two glass plates and an adhesive film, wherein at least one of the two glass plates is a conductive transparent glass-based circuit board with a glass substrate; and the adhesive film has a material of Poly(Vinyl Butyral) resin and is located between the two glass plates, wherein a surface of the glass substrate which is not contact with the adhesive film is provided with the conductive circuit by using an etching or photoetching technology. CN 104 464 883 A discloses a graphene conducting paste.

A laminated glass article of the prior art is commonly used as a safety glass article or a sound-insulated glass article in building and automotive fields. The laminated glass article of the prior art is essentially composed of two glass plates and an adhesive film. In general, the adhesive film has a material of Poly(Vinyl Butyral) (PVB) resin and is located between the two glass plates. With the advance of science and technology, a conductive circuit has been embedded in the laminated glass article for wildly used in industrial and smart home devices.

However, a glass-based circuit board in the laminated glass article of the prior art is commonly manufactured by a coating and etching process or a low-temperature silver paste process. The coating and etching process is to coat a conductive paste on a glass substrate and then to etch the conductive paste to form a conductive circuit. That is, the conductive circuit is bonded to the glass plate through an adhesive. Because glass molecules cannot chemically react with any element except fluorine, the coating and etching process is basically a spraying technique, which is a bonding process of organic materials mixing with conductive metal particles. The adhesive reduces the purity of the conductive paste so the conductive capability of the conductive circuit is very poor, wherein the electrical impedance of the best material is only 1×10⁻⁴ Ω. It is difficult to weld electronic components, and it is also difficult to implement functional circuits. The low-temperature silver paste process is to print a silver paste on a surface of a glass substrate through a screen printing technique, and then to bake and curing at a temperature of less than 200 ° C to form a conductive circuit. The low-temperature silver paste process cannot achieve high conductive capability because the silver paste contains a large amount of organic bonding materials. The electrical impedance of the conductive circuit can only reach 3×10⁻⁵ Ω. It is still difficult to weld electronic components, and it has poor adhesion. Due to the limitation of the two processes, the glass substrate and the conductive circuit are not tightly bonded, and a surface of the conductive circuit is higher than the surface of the glass substrate. Because a surface of the glass-based circuit board is not smooth, the conductive circuit is easily damaged and peeled off, resulting in poor conductive capability.

### DESCRIPTION OF THE INVENTION

For solving the above problems of the prior art, the present invention is to provide a highly conductive transparent laminated glass article. A conductive circuit is tightly fused with a glass substrate. It is a fusional relation between the conductive circuit and the glass substrate. A surface of the glass substrate and an upper surface of the conductive circuit are at the same level. Because a surface of the highly conductive transparent glass-based circuit board is smooth, the conductive circuit is not easily damaged. The highly conductive transparent glass-based circuit board has the characteristics of high conductivity and high transmittance. The highly conductive transparent laminated glass article is suitable for wildly used in industrial and smart home devices.

For solving the above problems of the prior art, the present invention is to provide a highly conductive transparent laminated glass article, which includes two glass plates and an adhesive film. The adhesive film has a material of Poly(Vinyl Butyral) (PVB) resin and is located between the two glass plates. At least one of the two glass plates is a highly conductive transparent glass-based circuit board with a glass substrate. A surface of the glass substrate is not contact with the adhesive film. A conductive paste, printed on the surface of the glass substrate, is baked, heated, and cooled to form a conductive circuit fused with the surface of the glass substrate. The conductive circuit is made essentially of a graphene layer or a conductive layer. The conductive layer has a graphene upper portion and a metal lower portion fused with the glass substrate, and a surface of the graphene upper portion is fused with a surface of the metal lower portion. The glass substrate is a glass-tempered substrate. A surface of the conductive circuit, except a region reserved for a solder pad used for welding a component, is covered with a printed-circuit-board (PCB) organic solder-resistant layer.

The surface of the glass substrate and an upper surface of the conductive circuit are at the same level.

The conductive paste includes conductive powder, low temperature glass powder, ethyl cellulose, terpineol, and dibutyl maleate. A mass ratio of conductive powder : low temperature glass powder : ethyl cellulose : terpineol: dibutyl maleate is 65 to 75 : 3 : 5 to 10 : 10 to 20 : 1 to 3. The conductive powder is graphene powder or a mixture of metal powder and graphene powder. When the conductive powder is the mixture of metal powder and graphene powder, the graphene powder accounts for 2% to 5% by mass of the conductive paste.

A surface of the glass-tempered substrate faces air, and the conductive paste, printed on the surface of the glass-tempered substrate, is baked at a temperature between 120 and 150 °C for 100 to 200 seconds, placed at a temperature between 550 and 600 °C for 300 to 360 seconds, then placed at a temperature between 710 and 730 °C °C for 120 to 220 seconds, and finally cooled to form the conductive circuit fused with the surface of the glass-tempered substrate.

The thickness of each of the two glass plates is 5 mm to 8 mm.

The thickness of the adhesive film is 1 mm to 2 mm.

The thickness of each of the two glass plates is 6 mm, and the thickness of the adhesive film is 1.14 mm.

The highly conductive transparent laminated glass article of the present invention has the advantages described as follows:
(1) The conductive circuit is tightly fused with the glass substrate. It is a fusional relation between the conductive circuit and the glass substrate. The highly conductive transparent glass-based circuit board has the characteristic of superconductivity, wherein the electrical impedance of the conductive circuit of the highly conductive transparent glass-based circuit board is lower than 5×10⁻⁸ Ω.
(2) The conductive circuit is fused with the glass substrate without any bonding medium so the conductive circuit has the characteristic of good thermal conductivity in high power applications. The conductive circuit is tightly fused with surface molecules of the glass substrate, wherein a surface-mounted-device (SMD) can be bonded on the conductive circuit and the surface-mounted-device (SMD) is not easily peeled off.
(3) The graphene powder accounts for 2% to 5% by mass of the conductive paste. Although the content of the graphene in the conductive paste is very little, the arrangement of molecules of the graphene are extremely dense, molecules of the graphene are light to enable to float on the surface of metal molecules, wear resistance of the graphene is higher than wear resistance of metal, and the graphene has high conductivity. Thus, the conductive circuit has still high conductivity. The graphene is almost transparent so that the highly conductive transparent glass-based circuit board has high light transmittance of more than 90%.
(4) The surface of the glass substrate and the upper surface of the conductive circuit are at the same level. Because a surface of the highly conductive transparent glass-based circuit board is smooth, the conductive circuit is not easily damaged.
(5) The conductive circuit is coated with the printed-circuit-board (PCB) organic solder-resistant layer, wherein the surface of the conductive circuit, except the region reserved for the solder pad used for welding the component, is covered with the printed-circuit-board (PCB) organic solder-resistant layer. This coated process of the present invention is named for the second coated process. The second coated process is used for protecting the conductive circuit and preventing oxidation of the surface of the conductive circuit so as to maintain the ability of superconductivity.

### BRIEF DESCRIPTION OF THE DRAWINGS

FIG. 1 is a schematic view showing the structure of a highly conductive transparent laminated glass article according to the present invention.
FIG. 2 is a schematic view showing the structure of a highly conductive transparent glass-based circuit board according to the present invention.
FIG. 3 is a cross sectional view taken along line A - A of FIG. 2 .
FIG. 4 is a cross sectional view showing the structure of a highly conductive transparent glass-based circuit board covered with a printed-circuit-board (PCB) organic solder-resistant layer according to the present invention.

In the figures: numeral 1 represents highly conductive transparent glass-based circuit board; numeral 1-1 represents glass substrate; numeral 1-2 represents conductive circuit; numeral 1-3 represents solder pad; numeral 1-4 represents PCB organic solder-resistant layer; numeral 1-5 represents graphene upper portion; numeral 1-6 represents metal lower portion; numeral 2 represents PVB adhesive film; and numeral 3 represents glass plates.

### PREFERRED EMBODIMENTS OF THE INVENTION

The present invention will be further described below in conjunction with accompanying drawings and exemplary embodiments.

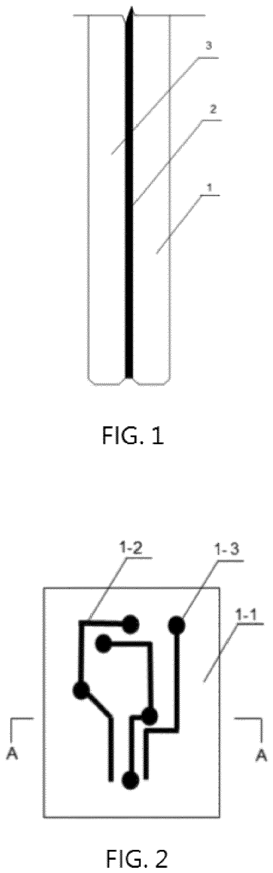

Please refer to FIGS. 1 to 3. The present invention provides a highly conductive transparent laminated glass article. The highly conductive transparent laminated glass article includes two glass plates 3 and an adhesive film 2. The adhesive film 2 has a material of Poly (Vinyl Butyral) (PVB) resin and is located between the two glass plates 3. At least one of the two glass plates 3 is a highly conductive transparent glass-based circuit board 1 with a glass substrate 1-1. A surface of the glass substrate 1-1 is not contact with the adhesive film 2. A conductive paste, printed on the surface of the glass substrate 1-1, is baked, heated, and cooled to form a conductive circuit 1-2 fused with the surface of the glass substrate 1-1. The conductive circuit 1-2 is a made essentially of a graphene layer or a conductive layer. The conductive layer has a graphene upper portion 1-5 and a metal lower portion 1-6 fused with the glass substrate 1-1, and a surface of the graphene upper portion 1-5 is fused with a surface of the metal lower portion 1-6. The surface of the glass substrate 1-1 and an upper surface of the conductive circuit 1-2 are at the same level.

The conductive paste includes conductive powder, low temperature glass powder, ethyl cellulose, terpineol, and dibutyl maleate. A mass ratio of conductive powder : low temperature glass powder : ethyl cellulose : terpineol: dibutyl maleate is 65 to 75 : 3 : 5 to 10 : 10 to 20 : 1 to 3. The conductive powder is graphene powder or a mixture of metal powder and graphene powder. When the conductive powder is the mixture of metal powder and graphene powder, the graphene powder accounts for 2% to 5% by mass of the conductive paste.

The glass substrate 1-1 is a glass-tempered substrate. A surface of the glass-tempered substrate faces air, and the conductive paste, printed on the surface of the glass-tempered substrate, is baked at a temperature between 120 and 150 °C for 100 to 200 seconds, placed at a temperature between 550 and 600 °C for 300 to 360 seconds, then placed at a temperature between 710 and 730 °C for 120 to 220 seconds, and finally cooled to form the conductive circuit 1-2 fused with the surface of the glass-tempered substrate.

The glass substrate 1-1 is the glass-tempered substrate.

The thickness of each of the two glass plates 3 is 5 mm to 8 mm.

The thickness of the adhesive film 2 is 1 mm to 2 mm.

The thickness of each of the two glass plates 3 is 6 mm, and the thickness of the adhesive film 2 is 1.14 mm.

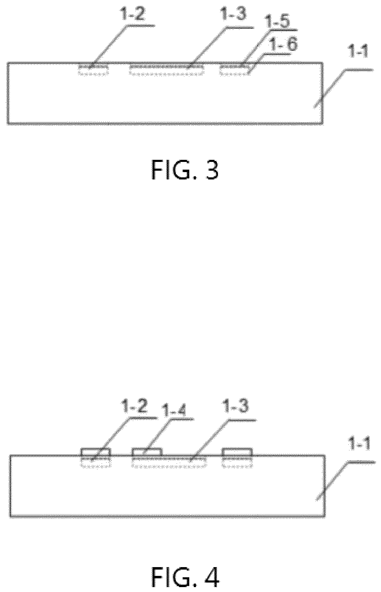

Please refer to FIG. 4. A surface of the conductive circuit 1-2, except a region reserved for a solder pad 1-3 used for welding a component, is covered with a printed-circuit-board (PCB) organic solder-resistant layer 1-4.

The manufacturing process of the highly conductive transparent glass-based circuit board 1 is described as follows:
Step (1): To print the conductive paste on the surface of the glass substrate 1-1, wherein the surface of the glass substrate 1-1 faces air. The conductive paste includes conductive powder, low temperature glass powder, ethyl cellulose, terpineol, and dibutyl maleate. A mass ratio of conductive powder : low temperature glass powder : ethyl cellulose : terpineol: dibutyl maleate is 65 to 75 : 3 : 5 to 10 : 10 to 20 : 1 to 3. The conductive powder is the graphene powder or the mixture of metal powder and graphene powder. When the conductive powder is the mixture of metal powder and graphene powder, the graphene powder accounts for 2% to 5% by mass of the conductive paste, wherein the shape of metal particles in the conductive paste is polyhedral.
Step (2): To bake the glass substrate 1-1, covered with the conductive paste, at a temperature between 120 and 150 °C for 100 to 200 seconds.
Step (3): To place the glass substrate 1-1 at a temperature between 550 and 600 °C for 300 to 360 seconds, then to place at a temperature between 710 and 730 °C for 120 to 220 seconds, and finally to cool to room temperature to form the conductive circuit 1-2 distributed on the surface of the glass substrate 1-1 and fused with the surface of the glass substrate 1-1, wherein the conductive circuit 1-2 is to form a part of the glass substrate 1-1.
Step (4): To coat the conductive circuit 1-2 with the printed-circuit-board (PCB) organic solder-resistant layer 1-4 by a screen printing technique, wherein the surface of the conductive circuit 1-2, except the region reserved for the solder pad 1-3 used for welding the component, is totally covered with the printed-circuit-board (PCB) organic solder-resistant layer 1-4. The printed-circuit-board (PCB) organic solder-resistant layer 1-4 is colorless. This coated process of the present invention is named for the second coated process.

In step (3), the glass substrate 1-1 can be tempered through a rapid cooling process. Thus, the glass substrate 1-1 of highly conductive transparent glass-based circuit board 1 is a glass-tempered substrate.

The conductive past has a special ratio of the mixture. In the baked process of the step (2) and the fused process of the step (3), the glass substrate 1-1 begins to soften at a temperature of 500 ° C, and surface molecules of the glass substrate 1-1 begin to be activated at a temperature of 550 ° C. The low-temperature glass powders are melted to bring the conductive powders to fused with activated surface molecules of the glass substrate 1-1; meanwhile, the terpineol and the dibutyl maleate in the conductive paste are volatilized at a high temperature. In this stage, surface molecules of the glass substrate 1-1 are not activated at a temperature of less than 550 °C, and the glass substrate 1-1 is easily broken at a temperature of more than 600 °C. After fused for 5 to 6 minutes, the conductive powders begin to be activated at a temperature around 720 ° C to fuse with more activated surface molecules of the glass substrate 1-1 for 2 to 4 minutes. In this stage, the temperature should not be less than 710 ° C or more than 730 ° C to prevent excessive deformation of the glass substrate 1-1. At this time, the molecules of the conductive powder have been fully fused with the surface of the glass substrate 1-1, and the fusion is a molecular level. The bonding force of the highly conductive transparent glass-based circuit board 1 is stronger than the bonding force of the glass-based circuit board of the traditional process using the adhesive. The surface of the glass substrate 1-1 and the surface of the conductive circuit 1-2 are at the same level to make the surface of the highly conductive transparent glass-based circuit board 1 smooth. The highly conductive transparent glass-based circuit board 1 is suitable for a variety of applications.

Metal particles in the conductive paste can be grinded into a shape of sphere, cube or irregular polyhedron, wherein the metal particles, grinded into the shape of cubes, can be arranged neatly for improving electrical conductivity. The graphene powder accounts for 2% to 5% by mass of the conductive paste. Although the content of the graphene in the conductive paste is very little, the arrangement of molecules of the graphene are extremely dense, molecules of the graphene are light to enable to float on the surface of metal molecules, wear resistance of the graphene is higher than wear resistance of metal, and the graphene has high conductivity. Thus, the conductive circuit 1-2 has still high conductivity. The graphene is almost transparent so the highly conductive transparent glass-based circuit board 1 has high light transmittance.

The second coated process is used for protecting the conductive circuit 1-2 and preventing oxidation of the surface of the conductive circuit 1-2. The traditional process is a coated process or paste process (e.g. sintering and coating film). The second coated process is that two materials are bond by intermolecular interpenetration so the two materials can be firmly bonded and cannot be easily peeled off. After the second coated process, the surface of the highly conductive transparent glass-based circuit board 1 is still smooth, and the solder pad 1-3 can be used for welding the component (e.g. an electronic component).

The highly conductive transparent glass-based circuit board 1 has a light transmittance of more than 90% and has the characteristic of superconductivity, wherein the electrical impedance of the conductive circuit 1-2 of the highly conductive transparent glass-based circuit board 1 is lower than 5×10⁻⁸ Ω. The conductive circuit 1-2 is bonding to the glass substrate 1-1 without any bonding medium so the conductive circuit 1-2 has the characteristic of good thermal conductivity in high power applications. The conductive circuit 1-2 is tightly fused with surface molecules of the glass substrate 1-1, wherein a surface-mounted-device (SMD) can be bonded on the conductive circuit 1-2 and the surface-mounted-device (SMD) is not easily peeled off.

The highly conductive transparent glass-based circuit board 1 is combined with the adhesive film 2 and the other glass plate of the two glass plates 3 to form the highly conductive transparent laminated glass article. The highly conductive transparent laminated glass article not only has the characteristics of heat insulation and sound insulation in the laminated glass article of the prior art, but also has the characteristics of high conductivity and high light transmittance. The highly conductive transparent laminated glass article is suitable for fabrication, manufacture, and use of industrial and smart-home devices.

## Claims

1. A highly conductive transparent laminated glass article, comprising two glass plates (3) and an adhesive film (2), **characterized in that**:
at least one of the two glass plates (3) is a highly conductive transparent glass-based circuit board (1) with a glass substrate (1-1); and
the adhesive film (2) has a material of Poly(Vinyl Butyral) resin and is located between the two glass plates (3),
wherein a surface of the glass substrate (1-1) is not contact with the adhesive film (2), and a conductive paste, printed on the surface of the glass substrate (1-1), is baked, heated, and cooled to form a conductive circuit (1-2) fused with the surface of the glass substrate (1-1);
wherein the conductive circuit (1-2) is made essentially of a graphene layer or a conductive layer having a graphene upper portion (1-5) and a metal lower portion (1-6) fused with the glass substrate (1-1), and a surface of the graphene upper portion (1-5) is fused with a surface of the metal lower portion (1-6);
wherein the glass substrate (1-1) is a glass-tempered substrate, and a surface of the conductive circuit (1-2), except a region reserved for a solder pad (1-3) used for welding a component, is covered with a printed-circuit-board organic solder-resistant layer (1-4);
wherein the conductive paste includes conductive powder, low temperature glass powder, ethyl cellulose, terpineol, and dibutyl maleate at a mass ratio of 65 to 75 : 3 : 5 to 10 : 10 to 20 : 1 to 3, and the conductive powder is graphene powder or a mixture of metal powder and graphene powder;
wherein, when the conductive powder is the mixture of metal powder and graphene powder, the graphene powder accounts for 2% to 5% by mass of the conductive paste; and
wherein a surface of the glass-tempered substrate faces air, and the conductive paste, printed on the surface of the glass-tempered substrate, is baked at a temperature between 120 and 150 °C for 100 to 200 seconds, placed at a temperature between 550 and 600 °C for 300 to 360 seconds, then placed at a temperature between 710 and 730 °C for 120 to 220 seconds, and finally cooled to form the conductive circuit (1-2) fused with the surface of the glass-tempered substrate.

2. The highly conductive transparent laminated glass article of claim 1, **characterized in that** the surface of the glass substrate (1-1) and an upper surface of the conductive circuit (1-2) are at the same level.

3. The highly conductive transparent laminated glass article of claim 1, **characterized in that** the thickness of each of the two glass plates (3) is 5 mm to 8 mm.

4. The highly conductive transparent laminated glass article of claim 1, **characterized in that** the thickness of the adhesive film (2) is 1 mm to 2 mm.

5. The highly conductive transparent laminated glass article of claim 3 or 4, **characterized in that** the thickness of each of the two glass plates (3) is 6 mm, and the thickness of the adhesive film (2) is 1.14 mm.

## Patentansprüche

1. Hochleitfähiger transparenter Verbundglasartikel mit zwei Glasscheiben (3) und einer Klebeschicht (2), **dadurch gekennzeichnet, dass**
mindestens eine der zwei Glasscheiben (3) eine hochleitfähige transparente auf Glas basierende Leiterplatte (1) mit einem Glassubstrat (1-1) ist; und die Klebeschicht (2) ein Material aus Poly-(Vinyl Butyral)-Harz aufweist und sich zwischen den zwei Glasscheiben (3) befindet,
wobei eine Oberfläche des Glassubstrats (1-1) nicht mit der Klebeschicht (2) in Kontakt ist und eine leitfähige Paste, die auf die Oberfläche des Glassubstrats (1-1) gedruckt ist, gebrannt, erhitzt und abgekühlt wird, um eine leitfähige Schaltung (1-2) zu bilden, die mit der Oberfläche des Glassubstrats (1-1) verschmolzen ist;
wobei die leitfähige Schaltung (1-2) im Wesentlichen aus einer Graphenschicht oder einer leitfähigen Schicht besteht, die einen oberen Graphenabschnitt (1-5) und einen unteren Metallabschnitt (1-6) aufweist, die mit dem Glassubstrat (1-1) verschmolzen sind, und wobei eine Oberfläche des oberen Graphenabschnitts (1-5) mit einer Oberfläche des unteren Metallabschnitts (1-6) verschmolzen ist;
wobei das Glassubstrat (1-1) ein glasgehärtetes Substrat ist und eine Oberfläche der leitfähigen Schaltung (1-2), ausgenommen ein für ein zum Schweißen einer Komponente verwendetes Lötpad (1-3) reservierter Bereich, mit einer organischen lötbeständigen Leiterplattenschicht (1-4) bedeckt ist;
wobei die leitfähige Paste leitfähiges Pulver, Niedrigtemperatur-Glaspulver, Ethylcellulose, Terpineol und Dibutylmaleat in einem Massenverhältnis von 65 bis 75 : 3 : 5 bis 10 : 10 bis 20 : 1 bis 3 enthält und das leitfähige Pulver Graphenpulver oder eine Mischung aus Metallpulver und Graphenpulver ist; wobei, wenn das leitfähige Pulver die Mischung aus Metallpulver und Graphenpulver ist, das Graphenpulver 2 % bis 5 % der Masse der leitfähigen Paste ausmacht; und
wobei eine Oberfläche des glasgehärteten Substrats Luft zugewandt ist und die leitfähige Paste, die auf die Oberfläche des glasgehärteten Substrats gedruckt ist, bei einer Temperatur zwischen 120 und 150 °C für 100 bis 200 Sekunden gebrannt wird, bei einer Temperatur zwischen 550 und 600 °C für 300 bis 360 Sekunden platziert wird, dann bei einer Temperatur zwischen 710 und 730 °C für 120 bis 220 Sekunden platziert wird und schließlich abgekühlt wird, um die leitfähige Schaltung (1-2) zu bilden, die mit der Oberfläche des glasgehärteten Substrats verschmolzen ist.

2. Hochleitfähiger transparenter Verbundglasartikel nach Anspruch 1, **dadurch gekennzeichnet, dass** sich die Oberfläche des Glassubstrats (1-1) und eine obere Fläche der leitfähigen Schaltung (1-2) auf der gleichen Ebene befinden.

3. Hochleitfähiger transparenter Verbundglasartikel nach Anspruch 1, **dadurch gekennzeichnet, dass** die Dicke jeder der zwei Glasscheiben (3) 5 mm bis 8 mm beträgt.

4. Hochleitfähiger transparenter Verbundglasartikel nach Anspruch 1, **dadurch gekennzeichnet, dass** die Dicke der Klebeschicht (2) 1 mm bis 2 mm beträgt.

5. Hochleitfähiger transparenter Verbundglasartikel nach Anspruch 3 oder 4, **dadurch gekennzeichnet, dass** die Dicke jeder der zwei Glasscheiben (3) 6 mm beträgt und die Dicke der Klebeschicht (2) 1,14 mm beträgt.

## Revendications

1. Article en verre feuilleté transparent hautement conducteur, comprenant deux plaques de verre (3) et un film adhésif (2), **caractérisé en ce que** :
au moins l'une des deux plaques de verre (3) est une carte de circuit imprimé à base de verre transparent hautement conducteur (1) avec un substrat de verre (1-1) ; et
le film adhésif (2) a un matériau de résine de poly(butyral de vinyle) et est situé entre les deux plaques de verre (3),
dans lequel une surface du substrat de verre (1-1) n'est pas en contact avec le film adhésif (2), et une pâte conductrice, imprimée sur la surface du substrat de verre (1-1), est cuite, chauffée et refroidie pour former un circuit conducteur (1-2) fusionné avec la surface du substrat de verre (1-1) ;
dans lequel le circuit conducteur (1-2) est réalisé essentiellement en une couche de graphène ou une couche conductrice ayant une partie supérieure en graphène (1-5) et une partie inférieure en métal (1-6) fusionnées avec le substrat de verre (1-1), et une surface de la partie supérieure en graphène (1-5) est fusionnée avec une surface de la partie inférieure en métal (1-6) ;
dans lequel le substrat de verre (1-1) est un substrat de verre trempé, et une surface du circuit conducteur (1-2), à l'exception d'une région réservée à une plage de soudure (1-3) utilisée pour souder un composant, est recouverte d'une couche organique résistant à la soudure (1-4) de carte de circuit imprimé ;
dans lequel la pâte conductrice comporte une poudre conductrice, une poudre de verre à basse température, l'éthylcellulose, le terpinéol et le maléate de dibutyle dans un rapport massique de 65 à 75 : 3 : 5 à 10 : 10 à 20 : 1 à 3, et la poudre conductrice est une poudre de graphène ou un mélange de poudre métallique et de poudre de graphène ;
dans lequel, lorsque la poudre conductrice est le mélange de poudre métallique et de poudre de graphène, la poudre de graphène représente 2 à 5% en masse de la pâte conductrice ; et
dans lequel une surface du substrat de verre trempé fait face à l'air, et la pâte conductrice, imprimée sur la surface du substrat de verre trempé, est cuite à une température comprise entre 120 et 150°C pendant 100 à 200 secondes, placée à une température comprise entre 550 et 600°C pendant 300 à 360 secondes, puis placée à une température comprise entre 710 et 730°C pendant 120 à 220 secondes, et enfin refroidie pour former le circuit conducteur (1-2) fusionné avec la surface du substrat de verre trempé.

2. Article en verre feuilleté transparent hautement conducteur de la revendication 1, **caractérisé en ce que** la surface du substrat de verre (1-1) et une surface supérieure du circuit conducteur (1-2) sont au même niveau.

3. Article en verre feuilleté transparent hautement conducteur de la revendication 1, **caractérisé en ce que** l'épaisseur de chacune des deux plaques de verre (3) est comprise entre 5 mm et 8 mm.

4. Article en verre feuilleté transparent hautement conducteur de la revendication 1, **caractérisé en ce que** l'épaisseur du film adhésif (2) est comprise entre 1 mm et 2 mm.

5. Article en verre feuilleté transparent hautement conducteur des revendications 3 ou 4, **caractérisé en ce que** l'épaisseur de chacune des deux plaques de verre (3) est égale à 6 mm, et l'épaisseur du film adhésif (2) est égale à 1,14 mm.
